# EUROPÄISCHE PATENTSCHRIFT

(11) **EP 3 174 656 B1**
(45) Veröffentlichungstag und Bekanntmachung des Hinweises auf die Patenterteilung: **07.07.2021**
(21) Anmeldenummer: 15710211.2
(22) Anmeldetag: 18.03.2015
(51) Int. Cl.: B22F 5/00, B22F 7/04, H01L 23/00, H05K 3/32

(54) **VERFAHREN ZUM VERBINDEN VON BAUELEMENTEN DURCH DRUCKSINTERN**
METHOD OF JOINING STRUCTURAL ELEMENTS BY MEANS OF PRESSURE SINTERING
PROCÉDÉ DE LIAISON DE COMPOSANTS PAR FRITTAGE SOUS PRESSION

(30) Priorität: 28.07.2014 EP 14178763
(43) Veröffentlichungstag der Anmeldung: 07.06.2017
(73) Patentinhaber: Heraeus Deutschland GmbH & Co. KG, 63450 Hanau (DE)
(72) Erfinder: SCHÄFER, Michael, 36093 Künzell (DE); SCHMITT, Wolfgang, 63110 Rodgau (DE)
(74) Vertreter: Heraeus IP
(86) Internationale Anmeldenummer: PCT/EP2015/055701
(87) Internationale Veröffentlichungsnummer: WO 2016/015878

(56) Entgegenhaltungen:
- EP-A1- 3 059 740
- EP-A2- 0 579 911
- EP-A2- 2 428 293
- DE-A1-102011 083 899
- US-A1- 2008 160 183
- US-A1- 2010 195 292

## Beschreibung

Die Erfindung betrifft ein Verfahren zum Verbinden von Bauelementen durch Drucksintern unter Verwendung eines metallischen Sintermittels mit Metalloxidoberflächen.

Bei den hierin erwähnten Metalloxidoberflächen oder Metalloxidschichten handelt es sich jeweils um äußere oder nach außen weisende Metalloxidoberflächen oder Metalloxidschichten. Bezüglich des in der weiteren Folge offenbarten metallischen Sintermittels kann es sich insbesondere auch um eine dessen gesamte äußere Oberfläche bedeckende und insofern nach außen weisende Metalloxidoberfläche oder Metalloxidschicht handeln.

US 2010/0195292 A1 offenbart Elektronikbauteile mit einer Silberelektrode, die mit einer äußeren Silberoxidschicht versehen ist. Die Silberoxidschicht kann zur direkten Sinteranbindung des Elektronikbauteils an eine damit zu verbindende Oberfläche genutzt werden, wobei das Silberoxid zu Silber reduziert wird.

US 2008/160183 A1 offenbart ein Sinterverbindungsverfahren, bei dem eine zu einer leitfähigen Schicht sinterfähige Zusammensetzung, die organisch gecoatete Metallpartikel und Silberoxidpartikel umfasst, zur Herstellung einer Sinterverbindung zwischen zu verbindenden Oberflächen verwendet wird. Die noch sinterfähige Zusammensetzung kann die Anwendungsform einer Tinte, einer Paste oder einer Sintervorform in Form eines schichtförmigen Presslings besitzen.

EP 0 579 911 A2 offenbart ein Verfahren zur Herstellung schlickergegossener isotroper Verbundwerkstoffe auf Kupferbasis. Dabei wird ein Mischschlicker auf ein geeignetes Substrat vergossen, ausgebrannt, gesintert und über Kaltwalz- und Anlassschritte zu einem massiven Band verarbeitet. Die Verbundwerkstoffe können zur Herstellung elektronischer Bauteile verwendet werden.

DE102011083899 offenbart ein Verfahren zum Verbinden von Bauteilen, bei dem man eine Anordnung aus wenigstens zwei jeweils eine metallische Kontaktoberfläche aufweisenden Bauelementen und zwischen den Bauelementen angeordnetem metallischen Sintermittel in Form eines diskreten metallischen Festkörpers mit Metalloxidoberflächen bereitstellt und die Anordnung drucksintert.

In der Elektronikindustrie ist die Verwendung von Metallsinterpasten oder von daraus durch Applikation und Trocknung hergestellten sinterfähigen (sinterbaren) Sintervorformen (sogenannte sinter preforms) zur Befestigung und elektrischen Kontaktierung von und zur Wärmeabfuhr aus Elektronikbauteilen wie beispielsweise Halbleiterchips bekannt.

So sind solche Metallsinterpasten und Sintervorformen beispielsweise am 17. Januar 2014 in der online-Publikation "Are Sintered Silver Joints Ready for Use as Interconnect Material in Microelectronic Packaging?" des Autors KIM S. SIOW im Journal of ELECTRONIC MATERIALS (DOI: 10.1007/s11664-013-2967-3) beschrieben. Beispiele für Patentliteratur zu Metallsinterpasten sind WO2011/026623A1, EP2425920A1, EP2428293A1 und EP2572814A1. Üblicherweise werden solche Metallsinterpasten durch Drucken, beispielsweise Sieb- oder Schab-Ionendruck, auf Trägersubstrate aufgebracht, gegebenenfalls getrocknet, mit Elektronikbauteilen bestückt und dann einem Sintervorgang unterworfen. Ohne den flüssigen Zustand zu durchlaufen, verbinden sich die Metallteilchen während des Sinterns durch Diffusion unter Ausbildung einer festen, elektrischen Strom und Wärme leitenden metallischen Verbindung zwischen Träger und Elektronikbauteil.

Wie von der Anmelderin festgestellt werden konnte, kann eine Befestigung zwischen Bauelementen unter Ausbildung einer Sinterverbindung allerdings auch ohne oder ohne direkte Verwendung einer Metallsinterpaste erzielt werden. Anstelle einer Metallsinterpaste kann überraschenderweise ein metallisches Sintermittel mit Metalloxidoberflächen verwendet werden.

Die Erfindung betrifft ein Verfahren zum Verbinden von Bauelementen gemäß Anspruch 1.

Der hier verwendete Wortlaut "wobei Metalloxidoberflächen des metallischen Sintermittels mit den metallischen Kontaktoberflächen der Bauelemente jeweils eine gemeinsame Kontaktfläche bilden" soll ausdrücklich auch die Fälle einschließen, in denen nur Flächenanteile der Metalloxidoberflächen des metallischen Sintermittels eine gemeinsame Kontaktfläche mit den metallischen Kontaktoberflächen der Bauelemente bilden.

Beim erfindungsgemäßen Verfahren werden wenigstens zwei Bauelemente verbunden. Dabei wird eine Anordnung aus wenigstens zwei jeweils eine metallische Kontaktoberfläche aufweisenden Bauelementen und zwischen den Bauelementen angeordnetem metallischen Sintermittel in Form eines metallischen Festkörpers mit Metalloxidoberflächen bereitgestellt und diese Anordnung in üblicher, dem Fachmann bekannter Weise unter Anwendung von mechanischem Druck und erhöhter Temperatur gesintert.

Unter dem Verbinden von wenigstens zwei Bauelementen wird das Befestigen von einem ersten Bauelement auf einem zweiten Bauelement verstanden. Im Rahmen der vorliegenden Erfindung bedeutet "auf" lediglich, dass eine metallische Kontaktoberfläche des ersten Bauelements mit einer metallischen Kontaktoberfläche des zweiten Bauelements über ein metallisches Sintermittel in Form eines metallischen Festkörpers mit Metalloxidoberflächen verbunden wird, wobei es auf die relative Lage der Bauelemente oder der Anordnung, die die Bauelemente umfasst, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Elektronik verwendet werden. Demgemäß kann es sich bei den Bauelementen beispielsweise um aktive Bauelemente (z.B. Halbleiterchips wie LEDs, Dioden, IGBTs, Thyristoren, MOSFETs, Transistoren, ICs), passive Bauteile (z.B. DCBs, Leadframes, Widerstände, Kondensatoren, Spulen, Induktivitäten, Memristoren, Clips, Kühlkörper), Piezokeramiken und Peltierelemente handeln.

Die zu verbindenden Bauelemente können gleichartige oder verschiedenartige Bauelemente sein.

Die Bauelemente haben jeweils eine metallische Kontaktoberfläche, wobei das Metall der metallischen Kontaktoberfläche ein reines Metall oder eine Metalllegierung sein kann. Die Legierungen weisen beispielsweise einen Anteil von > 50 Gew.-% des betreffenden Metalls auf.

Die Metalle der metallischen Kontaktoberflächen der zu verbindenden Bauelemente können gleich oder verschieden sein. Bevorzugt werden sie ausgewählt aus der aus Silber, Kupfer, Palladium und Legierungen dieser Metalle bestehenden Gruppe. Silber und Silberlegierungen sind besonders bevorzugt als Metall der metallischen Kontaktoberflächen.

Das oder die Bauelemente können aus Metall bestehen oder ihre metallische Kontaktoberfläche kann beispielsweise in Form einer Metallisierung vorliegen.

Beispielsweise kann es sich um eine durch Aufdampfen, chemische Galvanisierung, Elektrogalvanisierung oder durch Applikation aus einer Metallsinterzubereitung mit anschließendem Sintern hergestellte Metallisierung handeln. Beispiele für Metallsinterzubereitungen sind die eingangs schon erwähnten Metallsinterpasten.

Im Falle eines nicht ohnehin aus dem Metall bestehenden Bauelementes kann die metallische Kontaktoberfläche beispielsweise 100 nm bis 200 µm dick sein.

Wie das metallische Sintermittel, so können auch die metallischen Kontaktoberflächen eines der oder aller zu verbindenden Bauelemente eine Metalloxidschicht aufweisen. Bei dem Metalloxid einer solchen Metalloxidschicht kann es sich insbesondere um ein Oxid des Metalls der betreffenden metallischen Kontaktoberfläche handeln.

Bei dem metallischen Sintermittel handelt es sich um einen metallischen Festkörper mit Metalloxidoberflächen, d.h. mit einer Gesamtoberfläche oder mehreren diskreten Oberflächen jeweils in Form einer Metalloxidschicht. Es handelt sich bei dem metallischen Sintermittel also um einen diskreten, d.h. frei bzw. als einzelnes separates Teil vorliegenden, metallischen Festkörper. Das metallische Sintermittel liegt in Gestalt eines flachen oder schichtförmigen Metallteils vor, also als diskrete bzw. freie Metallschicht, welche besagte Metalloxidoberflächen aufweist. Die Dicke oder Schichtstärke des flachen oder schichtförmigen Metallteils liegt beispielsweise im Bereich von 10 bis 300 µm.

Das Metall des metallischen Sintermittels ist Silber.

Bei dem metallischen Sintermittel handelt es sich um einen schichtförmigen Metallsinterkörper, d.h. um eine gesinterte Metallstruktur in Form einer Schicht, mit anderen Worten, um eine als solche nicht mehr sinterfähige Metallstruktur. Eine solche gesinterte Metallstruktur umfasst außer den schon genannten äußeren Metalloxidoberflächen insbesondere kein Metalloxid, also kein Metalloxid in der Masse. Ein solcher schichtförmiger Metallsinterkörper ist nicht zu verwechseln mit einer der eingangs genannten noch sinterfähigen Sintervorformen. Das metallische Sintermittel in Gestalt eines schichtförmigen Metallsinterkörpers kann durch Applikation, beispielsweise mittels Siebdruck, Schablonendruck oder Sprühauftrag aus einer Metallsinterzubereitung auf ein Trägersubstrat mit einer zur Ausbildung einer Sinterverbindung unfähigen Oberfläche, anschliessendes Sintern der applizierten Metallsinterzubereitung mit oder bevorzugt ohne Anwendung von mechanischem Druck, gefolgt von Ablösen des so gebildeten schichtförmigen Metallsinterkörpers von der Oberfläche des Trägersubstrats hergestellt werden. Falls nach dieser Herstellungsabfolge keine oder eine nur unzureichende Metalloxidschicht auf der Oberfläche des schichtförmigen Metallsinterkörpers, beispielsweise durch Luftoxidation, entstanden ist, kann ein nachgeschalteter Oxidationsschritt zwecks Herstellung oder Verstärkung einer Metalloxidschicht auf der gesamten oder auf Teilen der äußeren Oberfläche des schichtförmigen Metallsinterkörpers angeschlossen werden. Dabei können die Oxidationsverfahren angewendet werden, wie sie in der weiteren Folge noch erläutert werden. Beispiele für bei der Herstellung eines solchen schichtförmigen Metallsinterkörpers verwendbare Metallsinterzubereitungen sind die eingangs schon erwähnten Metallsinterpasten.

Als bei der Herstellung der schichtförmigen Metallsinterkörper verwendbare Trägersubstrate mit einer zur Ausbildung einer Sinterverbindung unfähigen Oberfläche eignen sich beispielsweise Aluminiumoxidkeramiken, Nickelbleche, Polyimidfolien, Polytetrafluorethylenfolien und Silikonfolien. Für den Fachmann ist es dabei selbstverständlich, dass er - unabhängig von der Materialauswahl - ebene Trägersubstrate mit nichtporöser und hinreichend glatter Oberfläche auswählt.

Die Applikation der Metallsinterzubereitung, beispielsweise Siebdruck, Schablonendruck oder Sprühauftrag, sowie die Durchführung des Sinterns sind dem Fachmann bekannt, es bestehen keine methodische Besonderheiten, so dass auf eine detaillierte Beschreibung verzichtet werden kann und beispielhaft auf die eingangs schon genannte Literatur verwiesen wird. Auch das Ablösen vom Trägersubstrat mit zur Ausbildung einer Sinterverbindung unfähigen Oberfläche birgt keine Schwierigkeiten, da es während des Sintervorgangs praktisch zu einer Enthaftung des gebildeten schichtförmigen Metallsinterkörpers kommt.

Es ist möglich, das metallische Sintermittel, in Form des schichtförmigen Metallsinterkörpers im vom Betreiber des erfindungsgemäßen Verfahrens gewünschten Format herzustellen, so dass beim Betreiber kein Abfall in Form von Verschnitt entsteht. Ebenso kann es zweckmäßig sein, das metallische Sintermittel, insbesondere in Form des schichtförmigen Metallsinterkörpers als Endlosware herzustellen und beispielsweise noch auf dem Trägersubstrat befindlich oder schon davon abgelöst an den Verfahrensbetreiber zu liefern. Im Falle von Endlosware kann selbige mit Sollbruchstellen, beispielsweise mit Perforationen versehen sein, um beim Verfahrensbetreiber einfach und maßgerecht verwendet werden zu können. Im Falle von Endlosware ist Rollenware die bevorzugte Lieferform.

In jedem Falle weist das metallische Sintermittel besagte Metalloxidoberflächen auf, die mit den metallischen Kontaktoberflächen der Bauelemente jeweils eine gemeinsame Kontaktfläche bilden können. Dabei können die mit den metallischen Kontaktoberflächen der Bauelemente zur Bildung gemeinsamer Kontaktflächen fähigen Metalloxidoberflächen als diskrete, d.h. voneinander abgegrenzte Metalloxidoberflächen vorliegen. Sie können aber auch in Form einer kontinuierlichen Metalloxidschicht, die einen Teil der oder die gesamte Oberfläche des metallischen Sintermittels bedeckt, vorliegen. Im Falle des metallischen Sintermittels in Gestalt eines flachen oder schichtförmigen Metallteils befinden sich die Metalloxidoberflächen vorzugsweise auf dessen Vorder- und Rückseite, so dass die im erfindungsgemäßen Verfahren hergestellte Anordnung eine Sandwichstruktur hat, d.h. die Bauelemente der Anordnung aus den Bauelementen mit dazwischen angeordnetem metallischen Sintermittel befinden sich dann auf einander gegenüber liegenden Seiten des metallischen Sintermittels.

Bei dem Metalloxid der Metalloxidschicht oder der diskreten Metalloxidoberflächen des metallischen Sintermittels handelt es sich um ein Oxid des Metalls des metallischen Sintermittels. Die äußere oder nach außen weisende Metalloxidschicht ist fest mit dem darunter befindlichen Metall verbunden. Die Metalloxidschicht kann beispielsweise 0,02 bis 6 µm dick sein. Sie kann durch Oxidation, insbesondere durch Oxidation des betreffenden Metalls, bei Luftkontakt gebildet oder chemisch mittels Oxidationsmitteln oder durch anodische Oxidation der nicht, noch nicht, gering oder mehr oder minder stark oxidierten metallischen Oberfläche hergestellt oder verstärkt werden. Wie im vorhergehenden Satz schon angedeutet, kann eine schon vorhandene dünne Schicht des Metalloxids beispielsweise mittels anodischer Oxidation erzeugt oder verstärkt werden.

Beispielsweise kann eine nicht, teilweise oder anoxidierte Metalloberfläche anodisch oxidiert werden bis zur Ausbildung einer Metalloxidschichtdicke von beispielsweise 0,03 bis 5 µm. Im Falle einer Silberoberfläche kann eine Silberoxidschicht mit einer Schichtdicke von beispielsweise 0,05 bis 1 µm durch anodische Oxidation ausgebildet werden.

Die anodische Oxidation kann beispielsweise durch Eintauchen des als Anode geschalteten und an bzw. auf der Oberfläche zu oxidierenden metallischen Sintermittels in eine geeignete wässrige Elektrolytlösung durchgeführt werden. Als wässrige Elektrolytlösungen eignen sich beispielsweise wässrige 5 bis 10 gew.-%ige Lösungen von Natriumcarbonat, Natriumhydrogencarbonat, Kaliumhydroxid oder Natriumhydroxid. Die anodische Oxidation kann beispielsweise für 5 bis 30 Sekunden bei einer Gleichspannung im Bereich von 5 bis 20 Volt durchgeführt werden.

Im erfindungsgemäßen Verfahren werden Bauelemente durch Drucksintern mittels eines dazwischen angeordneten metallischen Sintermittels in Form des metallischen Festkörpers mit Metalloxidoberflächen miteinander verbunden, d.h. die Bauelemente und das dazwischen befindliche metallische Sintermittel werden durch Erhitzen und unter Anwendung mechanischen Drucks ohne, dass die Metalle der metallischen Kontaktoberflächen der Bauelemente sowie des metallischen Sintermittels die flüssige Phase erreichen, miteinander verbunden.

In Ausführungsform (I) des erfindungsgemäßen Verfahrens findet das Drucksintern in einer mindestens eine oxidierbare Verbindung enthaltenden Atmosphäre statt. Die oxidierbaren Verbindungen sind Kohlenmonoxid, Wasserstoff und Ameisensäure. Die Atmosphäre kann aus der mindestens einen oxidierbaren und gasförmig vorliegenden Verbindung bestehen oder letztere in Kombination mit inerten Gasen wie insbesondere Stickstoff und/oder Argon enthalten. Bevorzugt beträgt der Anteil an oxidierbaren Verbindungen in der Atmosphäre 1 bis 30 Volumen-%.

In Ausführungsform (II) des erfindungsgemäßen Verfahrens werden die Metalloxidoberflächen des metallischen Sintermittels und - falls die metallische Kontaktoberfläche wenigstens eines der mindestens zwei Bauelemente eine Metalloxidschicht aufweist - bevorzugt auch letztere vor Bildung der gemeinsamen Kontaktfläche mit mindestens einer, d.h. mit einer oder einer Mischung zweier oder mehrerer oxidierbarer organischer Verbindungen versehen.

Die oxidierbaren organischen Verbindungen weisen bevorzugt 1 bis 50, mehr bevorzugt 2 bis 24, noch mehr bevorzugt 6 bis 24 und noch mehr bevorzugt 8 bis 20 Kohlenstoffatome auf und haben wenigstens eine funktionelle Gruppe.

Als oxidierbare organische Verbindungen kommen freie Fettsäuren, Fettsäuresalze oder Fettsäureester zum Einsatz. Die freien Fettsäuren, Fettsäuresalze und Fettsäureester sind vorzugsweise unverzweigt. Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 bis 24, mehr bevorzugt 8 bis 18 Kohlenstoffatomen.

Bevorzugte oxidierbare organische Verbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte oxidierbare organische Verbindungen sind Dodecansäure, Octadecansäure, Aluminiumstearat, Kupferstearat, Natriumstearat, Kaliumstearat, Natriumpalmitat und Kaliumpalmitat.

Um die jeweilige Metalloxidschicht mit der mindestens einen oxidierbaren organischen Verbindung zu versehen, kann letztere beispielsweise unverdünnt als Wirksubstanz oder aus einer wässrigen Zubereitung oder aus einer Zubereitung in organischem Lösemittel auf die Oberfläche der Metalloxidschicht aufgetragen werden, gefolgt von einer Trocknung beispielsweise bei einer Objekttemperatur von 15 bis 50 °C während einer Trocknungsdauer von 10 bis 60 Minuten.

Hinsichtlich der Auftragsart gibt es keine prinzipielle Beschränkung; beispielsweise kann die Metalloxidschicht in die Zubereitung der mindestens einen oxidierbaren organischen Verbindung eingetaucht werden oder die Zubereitung der mindestens einen oxidierbaren organischen Verbindung kann auf die Metalloxidschicht aufgesprüht oder aufgepinselt werden. Bei der wässrigen Zubereitung oder der Zubereitung auf Basis organischen Lösemittels kann es sich um eine beispielsweise 1 bis 20 gew.-%ige Lösung, Dispersion oder Suspension der mindestens einen oxidierbaren organischen Verbindung handeln.

Das Verhältnis der Masse der mindestens einen oxidierbaren organischen Verbindung zur Fläche der mit der mindestens einen oxidierbaren organischen Verbindung zu versehenden bzw. versehenen Metalloxidschicht beträgt beispielsweise 0,0005 bis 10 g der mindestens einen oxidierbaren organischen Verbindung pro Quadratmeter Metalloxidfläche. Der Fachmann wird dieses Verhältnis angelehnt an die Metalloxidschichtdicke wählen, d.h. je höher die Metalloxidschichtdicke ist, je höher wird er das Verhältnis der Masse der mindestens einen oxidierbaren organischen Verbindung zur Fläche der mit der mindestens einen oxidierbaren organischen Verbindung zu versehenden Metalloxidschicht wählen.

Zwecks Herstellung der gemeinsamen Kontaktflächen werden die Bauelemente jeweils mit ihrer metallischen Kontaktoberfläche auf die betreffenden mit der mindestens einen oxidierbaren organischen Verbindung versehenen Metalloxidoberflächen des metallischen Sintermittels aufgesetzt. Der Überlappungsbereich der metallischen Kontaktoberflächen oder Flächenanteile derselben mit der betreffenden Metalloxidoberfläche definiert dabei die gemeinsame Kontaktfläche.

Die Anordnung aus den wenigstens zwei Bauelementen mit dem dazwischen befindlichen metallischen Sintermittel, welches die mit der wenigstens einen oxidierbaren organischen Verbindung versehenen Metalloxidoberflächen aufweist, wird schließlich einem Drucksinterprozess unterworfen.

Das eigentliche Drucksintern erfolgt bei einer Objekttemperatur von beispielsweise 200 bis 280 °C und der Prozessdruck liegt beispielsweise im Bereich von 1 bis unter 40 MPa, bevorzugt 5 bis 20 MPa. Die Sinterzeit liegt beispielsweise im Bereich von 1 bis 5 Minuten.

Falls ausschließlich gemäß der Ausführungsform (II) des erfindungsgemäßen Verfahrens gearbeitet wird, kann das Drucksintern in einer Atmosphäre erfolgen, die keinen besonderen Beschränkungen unterliegt, mit Ausnahme dessen, dass sie verschieden von der bei Ausführungsform (I) vorherrschenden Atmosphäre ist. Beispielsweise kann bei der Ausführungsform (II) eine Atmosphäre vorherrschen, die Sauerstoff enthält, oder es handelt sich um eine sauerstofffreie Atmosphäre. Unter sauerstofffreier Atmosphäre ist im Rahmen der Erfindung eine Atmosphäre, insbesondere eine Inertgasatmosphäre beispielsweise aus Stickstoff und/oder Argon, zu verstehen, deren Sauerstoffgehalt nicht mehr als 500 ppm, vorzugsweise nicht mehr als 10 ppm und noch mehr bevorzugt nicht mehr als 1 ppm beträgt.

Das Drucksintern wird in einer herkömmlichen, zum Drucksintern geeigneten Vorrichtung durchgeführt, in der sich die vorstehend beschriebenen Prozessparameter einstellen lassen.

### Ausführungsbeispiel 1

Auf ein Trägersubstrat in Form einer Polytetrafluorethylenfolie wurde eine 10 x 10 mm² große Schicht aus einer Silbersinterpaste (ASP 043-04P2 von Heraeus Materials Technology) in einer Nassschichtdicke von 100 µm mittels Schablonendruck aufgebracht und danach 30 min im Umlufttrockenschrank bei 250 °C Objekttemperatur gesintert.

Das gesinterte Produkt wurde vorsichtig unter Zuhilfenahme einer Saugpipette vom Trägersubstrat abgelöst; man erhielt einen freien schichtförmigen Silbersinterkörper.

In einem Edelstahlgefäß wurde eine 10 gew.-%ige wässrige Lösung von Natriumcarbonat vorgelegt und das Edelstahlgefäß mit der Kathode einer 10 V-Gleichspannungsquelle verbunden. Die Anode der Spannungsquelle wurde mit dem freien schichtförmigen Silbersinterkörper verbunden und letzterer für 30 Sekunden in die Natriumcarbonatlösung eingetaucht.

Nach dem Austauchen wurde die infolge anodischer Oxidation schwarz verfärbte Oberfläche des freien schichtförmigen Silbersinterkörpers mit deionisiertem Wasser gespült und getrocknet. Anschliessend wurde ein Tropfen einer 2 gew.-%igen Laurinsäurelösung in Exxsol™ D60 auf die vorder- und rückseitigen Silberoxid-Oberflächen gegeben, gleichmäßig verteilt und bei 70 °C im Umlufttrockenschrank getrocknet. Danach wurde der so mit Laurinsäure versehene Silbersinterkörper zwischen die Goldoberfläche eines entsprechenden DCB-Substrates und die Silberkontaktfläche eines 10 x 10 mm² großen IGBT gefügt und die so geschaffene Sandwichanordnung für 120 Sekunden bei 250 °C Objekttemperatur und einem mechanischen Druck von 20 MPa in einer Sinterpresse gesintert.

### Ausführungsbeispiel 2

In einem Edelstahlgefäß wurde eine 10 gew.-%ige wässrige Lösung von Natriumcarbonat vorgelegt und das Edelstahlgefäß mit der Kathode einer 10 V-Gleichspannungsquelle verbunden. Die Anode der Spannungsquelle wurde mit einem 3 cm langen, 3 mm breiten und 0,1 mm dicken Silberband der Fa. Schlenk Metallfolien verbunden und letzteres für 30 Sekunden in die Natriumcarbonatlösung eingetaucht.

Nach dem Austauchen wurde die infolge anodischer Oxidation schwarz verfärbte Silberoberfläche mit deionisiertem Wasser gespült und das Silberband getrocknet. Anschliessend wurde das anodisch oxidierte Silberband in eine 2 gew.-%ige Laurinsäurelösung in Exxsol™ D60 getaucht und nach dem Austauchen bei 70 °C im Umlufttrockenschrank getrocknet. Danach wurde das so präparierte Silberband zwischen die versilberte Kontaktfläche eines Kupferleadframes und die Silberkontaktfläche eines 2 x 2 mm² großen Si-Chips gefügt und die so geschaffene Sandwichanordnung für 120 Sekunden bei 250 °C Objekttemperatur und einem mechanischen Druck von 20 MPa in einer Sinterpresse gesintert.

Nach dem Sintern wurde die Haftung über die Scherfestigkeit bestimmt. Dabei wurden die Bauelemente mit einem Schermeißel bei einer Geschwindigkeit von 0,3 mm/s bei 20 °C abgeschert. Die Kraft wurde mittels einer Kraftmessdose aufgenommen (Gerät DAGE 2000 der Firma DA-GE, Deutschland). Tabelle 1 zeigt die mit den Beispielen 1 und 2 erhaltenen Ergebnisse.

**Tabelle 1**

| Beispiel | 1 | 2 |
|---|---|---|
| Scherfestigkeit (N/mm²) | 31 | 40 |

## Patentansprüche

1. Verfahren zum Verbinden von Bauelementen, bei dem man eine Anordnung aus wenigstens zwei jeweils eine metallische Kontaktoberfläche aufweisenden Bauelementen und zwischen den Bauelementen angeordnetem metallischen Sintermittel in Form eines diskreten metallischen Festkörpers mit Metalloxidoberflächen bereitstellt und die Anordnung drucksintert,
wobei Metalloxidoberflächen des metallischen Sintermittels mit den metallischen Kontaktoberflächen der Bauelemente jeweils eine gemeinsame Kontaktfläche bilden, und wobei (I) das Drucksintern in einer mindestens eine oxidierbare Verbindung enthaltenden Atmosphäre durchgeführt und/oder (II) die Metalloxidoberflächen vor Bildung der jeweiligen gemeinsamen Kontaktfläche mit mindestens einer oxidierbaren organischen Verbindung versehen werden,
wobei der metallische Festkörper ein flaches oder schichtförmiges Metallteil mit einer Dicke oder Schichtstärke im Bereich von 10 bis 300 µm ist,
wobei das Metall des metallischen Sintermittels Silber ist,
wobei das Metalloxid ein Oxid des Metalls des metallischen Sintermittels ist, wobei die mindestens eine oxidierbare organische Verbindung ausgewählt ist unter freien Fettsäuren, Fettsäuresalzen und Fettsäureestern, und
wobei die in der Atmosphäre enthaltene mindestens eine oxidierbare Verbindung ausgewählt ist aus der Gruppe bestehend aus Kohlenmonoxid, Wasserstoff und Ameisensäure.

2. Verfahren nach Anspruch 1,
wobei das Metallteil ein schichtförmiger Metallsinterkörper ist, erhältlich durch ein Verfahren umfassend die Schritte:
(1) Applizieren einer Metallsinterzubereitung auf ein Trägersubstrat mit einer zur Ausbildung einer Sinterverbindung unfähigen Oberfläche,
(2) Sintern der so applizierten Metallsinterzubereitung,
(3) Ablösen des in Schritt (2) gebildeten schichtförmigen Metallsinterkörpers von der Oberfläche des Trägersubstrats, sowie
(4) gegebenenfalls Herstellen oder Verstärken einer Metalloxidschicht auf der gesamten oder auf Teilen der äußeren Oberfläche des schichtförmigen Metallsinterkörpers im Zuge eines Schritt (3) nachgeschalteten Oxidationsschritts.

3. Verfahren nach Anspruch 2,
wobei das Trägersubstrat mit einer zur Ausbildung einer Sinterverbindung unfähigen Oberfläche ausgewählt ist aus der aus Aluminiumoxidkeramiken, Nickelblechen, Polyimidfolien, Polytetrafluorethylenfolien und Silikonfolien bestehenden Gruppe.

4. Verfahren nach einem der vorhergehenden Ansprüche,
wobei das metallische Sintermittel eine Vorder- und eine Rückseite aufweist, auf denen sich jeweils Metalloxidoberflächen befinden.

5. Verfahren nach einem der vorhergehenden Ansprüche,
wobei die Metalloxidschicht oder Metalloxidoberfläche durch Luftkontakt gebildet oder chemisch mittels Oxidationsmitteln oder durch anodische Oxidation hergestellt oder verstärkt worden ist.

6. Verfahren nach einem der vorhergehenden Ansprüche,
wobei es sich bei den Bauelementen um in der Elektronik verwendete Teile handelt.

7. Verfahren nach einem der vorhergehenden Ansprüche,
wobei die Metalle der metallischen Kontaktoberfläche der zu verbindenden Bauelemente gleich oder verschieden und aus der aus Silber, Kupfer, Palladium und Legierungen dieser Metalle bestehenden Gruppe ausgewählt sind.

8. Verfahren nach einem der vorhergehenden Ansprüche,
wobei die metallische Kontaktoberfläche wenigstens eines der wenigstens zwei Bauelemente eine Metalloxidschicht aufweist.

9. Verfahren nach Anspruch 8,
wobei die Metalloxidschicht des wenigstens einen der wenigstens zwei Bauelemente vor Bildung der gemeinsamen Kontaktfläche mit mindestens einer oxidierbaren organischen Verbindung versehen wird.

10. Verfahren nach einem der vorhergehenden Ansprüche,
wobei das Verhältnis der Masse der mindestens einen oxidierbaren organischen Verbindung zur Fläche der betreffenden Metalloxidschicht 0,0005 bis 10 g pro Quadratmeter Metalloxidfläche beträgt.

11. Verfahren nach einem der vorhergehenden Ansprüche,
wobei die mindestens eine oxidierbare organische Verbindung aus einer wässrigen Zubereitung oder aus einer Zubereitung in organischem Lösemittel auf die Metalloxidschicht aufgebracht wird.

12. Verfahren nach Anspruch 11,
wobei es sich bei der Zubereitung um eine Lösung, Dispersion oder Suspension handelt.

## Claims

1. A method for connecting components, in the case of which an assembly of at least two components each having a metallic contact surface and a metallic sintering agent in the form of a discrete metallic solid body comprising metal oxide surfaces and being arranged between the components, is provided, and the assembly is pressure sintered,
wherein metal oxide surfaces of the metallic sintering agent each form a common contact surface with the metallic contact surfaces of the components, and wherein (I) the pressure sintering is carried out in an atmosphere containing at least one oxidizable compound, and/or (II) the metal oxide surfaces are provided with at least one oxidizable organic compound before formation of the respective common contact surface,
wherein the metallic solid body is a flat or layer-shaped metal part with a thickness or layer thickness in the range of from 10 to 300 µm,
wherein the metal of the metallic sintering agent is silver,
wherein the metal oxide is an oxide of the metal of the metallic sintering agent, wherein the at least one oxidizable organic compound is selected among free fatty acids, fatty acid salts, and fatty acid esters, and
wherein the at least one oxidizable compound contained in the atmosphere is selected from the group consisting of carbon monoxide, hydrogen, and formic acid.

2. The method according to claim 1,
wherein the metal part is a layer-shaped metal sintering body, which can be obtained by means of a method comprising the steps of:
(1) applying a metal sintering preparation onto a support substrate comprising a surface, which is incapable of forming a sintered connection,
(2) sintering the metal sintering preparation applied in this way,
(3) detaching the layer-shaped metal sintering body formed in step (2) from the surface of the support substrate, as well as
(4) optionally producing or reinforcing a metal oxide layer on the entire or on parts of the outer surface of the layer-shaped metal sintering body as part of an oxidation step downstream from step (3).

3. The method according to claim 2,
wherein the support substrate comprising a surface, which is incapable of forming a sintered connection, is selected from the group consisting of aluminum oxide ceramics, nickel sheets, polyimide films, polytetrafluoroethylene films, and silicon films.

4. The method according to any one of the preceding claims,
wherein the metallic sintering agent has a front and a rear side, on which metal oxide surfaces are located in each case.

5. The method according to any one of the preceding claims,
wherein the metal oxide layer or metal oxide surface has been formed by air contact or has been produced or reinforced chemically by means of oxidizing agents or by means of anodic oxidation.

6. The method according to any one of the preceding claims,
wherein the components are parts used in electronics.

7. The method according to any one of the preceding claims,
wherein the metals of the metallic contact surface of the components to be connected are identical or different and are selected from the group consisting of silver, copper, palladium, and alloys of these metals.

8. The method according to any one of the preceding claims,
wherein the metallic contact surface of at least one of the at least two components has a metal oxide layer.

9. The method according to claim 8,
wherein the metal oxide layer of the at least one of the at least two components is provided with at least one oxidizable organic compound before formation of the common contact surface.

10. The method according to any one of the preceding claims,
wherein the ratio of the mass of the at least one oxidizable organic compound to the surface area of the respective metal oxide layer is 0.0005 to 10 g per square meter of metal oxide surface.

11. The method according to any one of the preceding claims,
wherein the at least one oxidizable organic compound is applied to the metal oxide layer from an aqueous preparation or from a preparation in organic solvent.

12. The method according to claim 11,
wherein the preparation is a solution, dispersion, or suspension.

## Revendications

1. Procédé permettant de connecter des éléments de construction, dans lequel on fournit une disposition d'au moins deux éléments de construction présentant respectivement une surface de contact métallique et un agent de frittage métallique sous la forme d'un corps solide métallique discret avec surfaces d'oxyde métallique, disposé entre les éléments de construction, et dans lequel on réalise un frittage sous pression de la disposition,
les surfaces d'oxyde métallique de l'agent de frittage métallique formant une surface de contact commune avec les surfaces de contact métalliques des éléments de construction, et
(I) le frittage sous pression étant réalisé dans une atmosphère contenant au moins un composé oxydable et/ou (II) les surfaces d'oxyde métallique étant dotées au moins d'un composé organique oxydable avant la formation de la surface de contact commune respective,
le corps solide métallique étant une pièce en métal plate ou sous la forme d'une couche, avec une épaisseur ou une couche de l'ordre de 10 à 300 µm, le métal de l'agent de frittage métallique étant de l'argent,
l'oxyde métallique étant un oxyde du métal de l'agent de frittage métallique, au moins un composé organique oxydable étant sélectionné parmi les acides gras libres, les sels d'acides gras et les esters d'acides gras, et
au moins un composé oxydable contenu dans l'atmosphère étant sélectionné dans le groupe composé de monoxyde de carbone, d'hydrogène et d'acide formique.

2. Procédé conformément à la revendication 1,
la pièce en métal étant un corps de frittage métallique sous la forme d'une couche, disponible par un procédé comprenant les étapes suivantes :
(1) application d'une préparation de frittage métallique sur un substrat de support avec une surface inapte à la formation d'une liaison de frittage,
(2) frittage de la préparation de frittage métallique ainsi appliquée,
(3) détachement du corps de frittage métallique sous la forme d'une couche, formé dans l'étape (2), de la surface du substrat de support et
(4) le cas échéant, fabrication ou consolidation d'une couche d'oxyde métallique sur toute ou sur des parties de la surface extérieure du corps de frittage métallique sous la forme d'une couche, au cours d'une étape d'oxydation réalisée en aval d'une étape (3).

3. Procédé conformément à la revendication 2,
le substrat de support avec une surface inapte à la formation d'une liaison de frittage étant sélectionné dans le groupe composé de céramiques d'oxyde d'aluminium, de plaques de nickel, de films de polyimide, de films de polytétrafluoroéthylène et de films en silicone.

4. Procédé conformément à l'une des revendications précédentes,
l'agent de frittage métallique présentant une face avant et une face arrière, sur lesquels se trouvent respectivement des surfaces d'oxyde métallique.

5. Procédé conformément à l'une des revendications précédentes,
la couche d'oxyde métallique ou surface d'oxyde métallique ayant été formée par contact avec l'air ou fabriquée ou consolidée chimiquement au moyen d'agents oxydants ou par oxydation anodique.

6. Procédé conformément à l'une des revendications précédentes,
les éléments de construction étant des pièces utilisées en électronique.

7. Procédé conformément à l'une des revendications précédentes,
les métaux de la surface de contact métallique des éléments de construction à connecter étant identiques ou différents et étant sélectionnés dans le groupe composé d'argent, de cuivre, de palladium et d'alliages de ces métaux.

8. Procédé conformément à l'une des revendications précédentes,
la surface de contact métallique au moins de l'un des au moins deux éléments de construction présentant une couche d'oxyde métallique.

9. Procédé conformément à la revendication 8,
la couche d'oxyde métallique au moins de l'un des au moins deux éléments de construction étant dotée d'au moins un composé organique oxydable avant la formation de la surface de contact commune.

10. Procédé conformément à l'une des revendications précédentes,
le rapport entre le poids d'au moins un composé organique oxydable et la surface de la couche d'oxyde métallique en question étant de 0,0005 à 10 g par mètre carré de surface d'oxyde métallique.

11. Procédé conformément à l'une des revendications précédentes,
au moins un composé organique oxydable à partir d'une préparation aqueuse ou d'une préparation dans un solvant organique étant appliqué sur la couche d'oxyde métallique.

12. Procédé conformément à la revendication 11,
la préparation étant une solution, une dispersion ou une suspension.
